Europäisches Patentamt

European Patent Office

Office européen des brevets

(11) Publication number: **0 228 863 B1**

# EUROPEAN PATENT SPECIFICATION

(45) Date of publication of patent specification: **11.03.92**   (51) Int. Cl.5: **H01L 21/302**

(21) Application number: **86309819.0**

(22) Date of filing: **16.12.86**

(54) **Method of dividing a substrate into a plurality of substrate portions.**

(30) Priority: **20.12.85 JP 287442/85**

(43) Date of publication of application:
**15.07.87 Bulletin 87/29**

(45) Publication of the grant of the patent:
**11.03.92 Bulletin 92/11**

(84) Designated Contracting States:
**DE GB**

(56) References cited:
**GB-A- 1 098 398**
**GB-A- 1 491 705**
**US-A- 4 016 590**

**PATENT ABSTRACTS OF JAPAN, vol. 7, no. 4
(E-151)[1149], 8th January 1983; & JP-A-57
164 584**

(73) Proprietor: **SEIKO INSTRUMENTS INC.**
**31-1, Kameido 6-chome Koto-ku**
**Tokyo 136(JP)**

(72) Inventor: **Kawahara, Yukito**
**31-1, Kameido 6-chome Koto-ku**
**Tokyo(JP)**
Inventor: **Mukainakano, Hiroshi**
**31-1, Kameido 6-chome Koto-ku**
**Tokyo(JP)**
Inventor: **Machida, Satoshi**
**31-1, Kameido 6-chome Koto-ku**
**Tokyo(JP)**

(74) Representative: **Miller, Joseph et al**
**J. MILLER & CO. Lincoln House 296-302 High
Holborn**
**London WC1V 7JH(GB)**

EP 0 228 863 B1

## Description

This invention concerns a method of making semi-conductor chips and, although the invention is not so restricted, it relates more particularly to the production of an image sensor in which a plurality of semiconductor chips having circuits formed thereon are assembled together to form an image sensor.

Semiconductor devices exist which are adapted to receive the light reflected from a document irradiated with light and to convert the received light into an electric signal. In one such semiconductor device, a plurality of semiconductor chips are connected together to form a continuous or elongated line sensor having the same size as that of a particular document so as to be capable of reading the document with a magnification of x1.

Recently, various kinds of contact-type image sensors used as small-sized image input devices for business machines, computers, etc. have been actively developed. Contact-type image sensors need to have a continuous or elongated line sensor which has the same size as that of a particular document for the purpose of reading the document at a magnification of x1. There is a trend to attempt to produce an elongated contact-type image sensor by connecting together a plurality of silicon IC chips for which a manufacturing technique has already been devised and which are extremely reliable.

In this case, any error in the connection between each pair of adjacent IC chips limits the resolving power of the contact-type image sensor when reading. In the production of a high-resolving power contact-type image sensor, the condition of the end surfaces (diced surfaces) of each IC chip is a very important factor. In addition, since the higher the resolving power, the smaller the distance between each pair of adjacent sensors, it is necessary to precisely maintain the distance between the sensors respectively located on opposite sides of the joint therebetween.

In US-A-4,016,590 there is disclosed a method of making semi-conductor chips comprising producing a plurality of semi-conductor chips each of which is of trapezium shape and has an obverse side provided with a circuit, a reverse side which is shorter than the obverse side and first and second sides each of which extends between the obverse and reverse sides.

A similar disclosure is made in GB-A-1,098,398 except that in the latter the obverse side is not provided with the said circuit.

In the case of US-A-4,016,590 all the sides of the chips are produced by bevelling and subsequent etching. In the case of GB-A-1,098,398, the chips are produced by cutting a silicon lamination with diamond saw blades having V-shaped tips.

According, however, to the present invention there is provided a method of making semi-conductor chips comprising producing a plurality of semiconductor chips each of which is of trapezoidal crosssection and has an obverse side provided with a circuit, a reverse side which is shorter than the obverse side, and first and second sides each of which extends between the, obverse and reverse sides characterised in that a semiconductor member is first mounted on a support surface which is disposed at an acute angle to a dicing saw and the latter is operated to effect a plurality of first cuts in the semi-conductor member so as to produce the said first sides of the chips while the latter remain connected to each other; rotating the so-cut semi conductor member through 180°, and operating the dicing saw to effect a plurality of second cuts in the semi-conductor member so as to provide the said chips with the said second sides.

The said acute angle may be arranged to be

$$\theta = arc.tan\left(\frac{2t}{\ell}\right),$$

where $t$ = the thickness of the substrate and $\ell$ equals the difference between the lengths of the said obverse and reverse sides.

Preferably, the obverse side is at least $10\mu$ longer than the reverse side.

The circuit may include a light-receiving or a light-emitting element.

Preferably, the semiconductor chips are assembled to form an image sensor.

The invention is illustrated, merely by way of example, in the accompanying drawings, in which:-

Figures 1A to 1C are sectional views illustrating sequential steps of a method according to the present invention, and

Figures 2(A) to 2(I) are sectional views illustrating known methods.

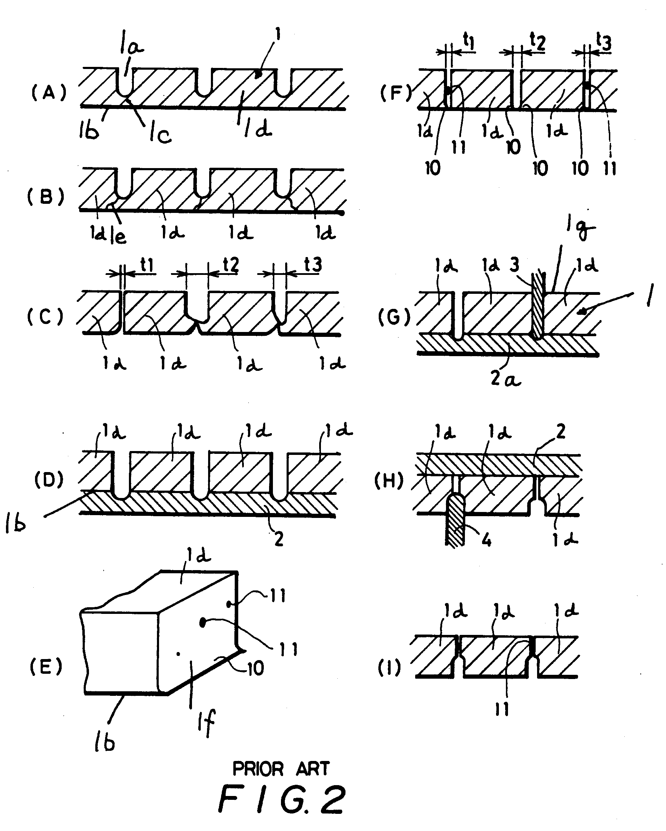

Figure 2 illustrates a number of known methods for producing a semi conductor device.

As shown in Figure 2(A), a semiconductor substrate 1 is cut using a dicing saw (not shown in Figure 2(A)) so as to form therein a plurality of longitudinally spaced apart cuts 1a, and so that the reverse side 1b of the substrate 1 is left uncut at portions 1c having a thickness of several tens to several hundreds of microns. Then pressure is applied to the substrate 1 to break the latter at the portions 1c so that the substrate 1 becomes divided into a plurality of semi conductor chips 1d. With this method, however, the end surfaces of the uncut portions 1c cannot be made uniform due to, for example, the crystalline properties of the substrate 1 and the way in which the pressure is applied to the substrate 1. This is shown in Figure 2(B) where the said end surfaces are shown at 1e.

Figure 2(C) shows a plurality of semiconductor IC chips 1d cut by another known method and connected together. The reference symbols $t_1$, $t_2$ and $t_3$ shown in Figure 2(C) respectively represent chip connection errors. As illustrated, chip spacings are not uniform, and there are large variations in the chip spacing. As a result, the sensor spacing between each pair of opposing connection surfaces is non-uniform, which means that it is impossible to obtain a contact-type image sensor of high resolving power and high accuracy.

A through-cut method of producing a semiconductor device is also known, the through-cut method representing an improvement over the methods illustrated in Figures 2(A), 2(B), and 2(C). According to the through-cut method, a semiconductor substrate 1 is cut to the reverse surface 1b thereof in a single dicing step without any portion of the substrate 1 being left uncut. This through-cut method will be explained below with reference to Figure 2(D). The reference numeral 1 denotes a semiconductor substrate having circuits (not shown) formed thereon, and the numeral 2 denotes an adhesive sheet. The adhesive sheet 2 is provided to enable the resultant semiconductor chips 1d to remain interconnected after the substrate 1 has been fully cut through. The adhesive sheet 2 also protects a substrate support member or stage (not shown) of a dicing saw from being damaged. This method, however, still fails to eliminate uncut portions completely.

Figure 2(E) shows a cut surface of a semiconductor chip 1d cut by the through-cut method. As a result of observation using a scanning electron microscope, it has been found that there are several "chippings" or projections 10 of 5 $\mu$m to 10 $\mu$m near the reverse surfaces 1b of the semiconductor chips 1d and a few particles 11 of dust which may be regarded as silicon powder particles and which are attached to the side surfaces 1f of the semiconductor chips 1d.

Figure 2(F) shows a plurality of such IC chips connected together. The chip connection errors $t_1$, $t_2$, and $t_3$ are reduced and uniformity is improved as compared with the method shown in Figure 2-(C). However, the distance between each pair of adjacent semiconductor chips 1d is not satisfactorily small.

In order to overcome these problems, still another dicing method has already been proposed and this method will be explained below with reference to Figures 2(G) and 2(H). In a first step, through-cutting is effected from the obverse surface 1g of a semiconductor substrate 1 as shown in Figure 2(G). After the completion of this step, the obverse surface 1g is washed and dried, and an adhesive sheet 2 (Figure 2(H)) is stuck to the obverse surface 1g, while an adhesive sheet 2a which was attached to the reverse surface 1b, is separated therefrom. In a second step, the substrate 1 is diced from the reverse surface using a wider blade 4 than the blade 3 employed in the first step. This step is shown in Figure 2(H). Figure 2(I) shows a plurality of IC chips 1d thus obtained and connected together. Thus, the uniformity of the gaps between the adjacent surfaces of the chips 1d is improved, and the distance between each pair of adjacent IC chips 1d is also reduced by a large margin, so that the degree of accuracy in connection is increased. This dicing method is, however, complicated as compared with the other known methods, and it is therefore difficult to improve the manufacturing yield (i.e. the proportion of satisfactory chips) in the dicing step. In addition, it is impossible to eliminate the effect of particles 11 of dust attached to the cut surfaces.

The method illustrated in Figures 2(G), 2(H), 2-(I) is disclosed in Japanese Patent Application No. 12346/1984, filed January 25th, 1984, and laid open to public inspection as No. 157236/1985.

As described above to connect together semiconductor chips with a high degree of accuracy, it has previously proved necessary for a complicated dicing step to be carried out, and with a relatively simple known method it has not been possible to make uniform the cross-sectional shape of each of the cut semiconductor chips, and the degree of accuracy in their connection together has also been non-uniform. In addition, since the gap at each "joint" between adjacent semiconductor chips has been too wide, it has heretofore been difficult to produce a contact-type image sensor of high resolving power and high accuracy at low cost.

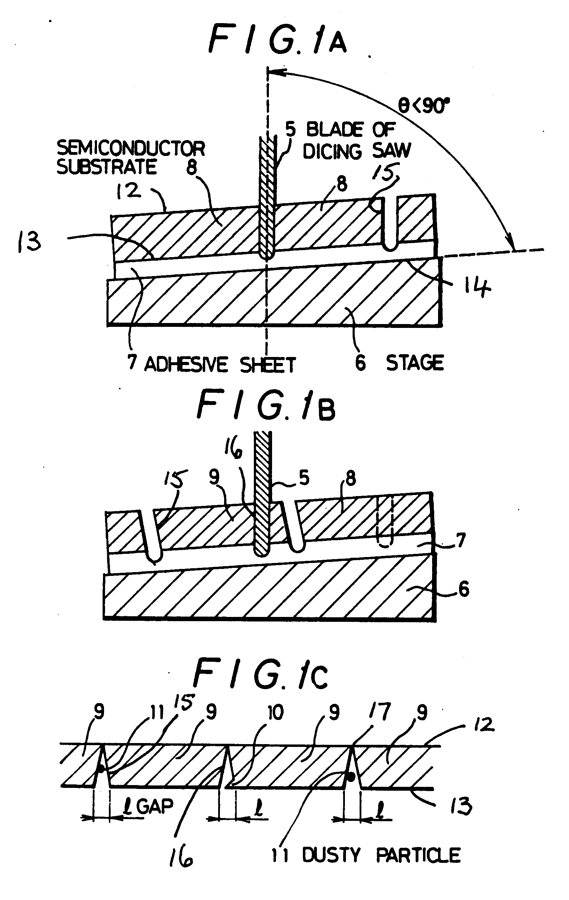

One embodiment of the present invention will now be described with reference to Figures 1A, 1B and 1C of the accompanying drawings.

Figures 1A and 1B illustrate in combination a method of cutting a substrate to form semiconductor chips according to the present invention.

As shown in Figure 1A, a semiconductor substrate or wafer 8 has an obverse surface 12 and a reverse surface 13. An adhesive sheet or tape 7 is stuck to the reverse surface 13, the adhesive tape 7 being first suction-held on a surface 14 of a support stage 6. The angle $\theta$ between the surface 14 of the stage 6 and a blade 5 of a dicing saw is an acute angle, and through-cutting of the substrate 8 in a plurality of places is effected in this state, thereby cutting one side 15 of each of a plurality of desired semiconductor chips 9, the chips 9 being interconnected at this stage by the adhesive tape 7. Then, the semiconductor substrate 8 is no longer suction held to the stage 6, is rotated through 180° in its own plane, and is suction-held on the stage 6 again. As a result, the other side of each chip 9 which is opposite the previously cut side 15 thereof, is cut as shown in Figure 1B. Figure 1C shows a plurality of semiconductor chips 9 which have been thus cut and which have been connected together at their chip joints 17 after the tape 7 has been removed. Thus, the uniformity of the gap at each chip joint 17 is improved and the gap dimension $\ell$ is reduced by a large margin, so that it is possible to increase the accuracy of the connection. Thus each chip 9, in cross section, is a trapezium whose obverse side 12 is longer than its reverse side 13. As a result, there are triangular gaps between adjacent chips 9, and these gaps provide space for at least most of the "chippings" 10 and particles of dust 11.

It has been observed that most of the "chippings" 10 are constituted by projections produced near the reverse surface 13 and are of about 6 to 8 $\mu$m in length, and most of the particles 11 of dust are attached to the cut side surfaces 15, 16 and are of 5 $\mu$m or less. Therefore, in order to reduce or eliminate the effects of such "chippings" 10 and particles 11, the gap $\ell$ at the reverse surface 13 between adjacent semiconductor chips should desirably be at least 10 $\mu$m. Put differently, the obverse side 12 of each chip 9 should preferably be at least 10 $\mu$m longer than the reverse side 13 thereof.

The angle $\theta$ (shown in Figure 1A) between the axis of the blade 5 and the stage surface 14 is determined by using the thickness t of the substrate 8 in accordance with the following formula:

$$\theta = arc. \tan\left(\frac{2t}{\ell}\right)$$

Accordingly, to cut a substrate 8 of 300 $\mu$m thickness so that the gap $\ell$ is 10 $\mu$m, it is only necessary to set the angle $\theta$ between the axis of the blade 5 and the stage surface 14 such as to be 89°.

By connecting together a plurality of semiconductor chips 9 having such a configuration, it is possible to produce a contact-type image sensor of high resolving power.

Moreover, if the invention is applied to semiconductor chips 9 having light-emitting elements, it is also possible to produce a high-density light source for a contact-type LED printer.

It should be noted that, although in the above-described embodiment the surface 14 of the stage 6 of the dicing saw is inclined, another possibility is for the blade 5 to be inclined with the stage surface 14 held horizontal as usual. This may be better than the first-mentioned arrangement in terms of operability. In the case where, with the angle $\theta$ between the axis of the blade 5 and the support surface 14 fixed, one side of a chip is first cut and the other opposing side is then cut, it is possible to effect cutting simply by turning the stage 6 through 180° while keeping the substrate 8 suction-held on the stage 6. It is therefore possible to eliminate the need for carrying out the step of removing the substrate 8 from the stage 6 and suction holding the substrate 8 on the stage 6 again after the substrate 8 has been turned through 180°, as described with reference to Figure 1. In addition, it is easy to obtain the required height of the tip of the blade 5 with respect to the stage surface 14. Thus, the blade 5 may be inclined with the stage surface 14 held horizontal as usual. Alternatively, both the methods described above may be combined together.

Depending on the angle of inclination, the object of the present invention can be attained even by half-cutting.

The invention is also applicable to an LED array which constitutes a light source for a contact-type LED printer.

As will be clear from the above description, when chips 9 cut in accordance with the present invention are connected together, it is possible to improve the uniformity of the gaps therebetween and reduce the gap dimension, which cannot be achieved by the prior art. As a result, the degree of accuracy in arranging sensors on opposite sides of each junction is increased, and it is possible to produce a contact-type image sensor of high resolving power and high accuracy. In addition, the increased accuracy enables enlargement of the effective light-receiving area of the sensor and permits the output to be increased advantageously. Further, the present invention is also applicable to a light-emitting element, and it is thus possible to produce a high-density LED array light source for an LED printer by a simple and easy dicing method.

## Claims

1. A method of making semi-conductor chips comprising producing a plurality of semi-conductor chips (9) each of which is of trapezoidal crosssection and has an obverse side (12) provided with a circuit, a reverse side (13) which is shorter than said obverse side (12), and first and second sides (15,16) each of which extends between said obverse and reverse sides (12, 13) characterised in that a semi-conductor member (8) is first mounted on a support surface (14) which is disposed at an acute angle to a dicing saw (5) and said dicing saw is operated to effect a plurality of first cuts in the semi-conductor member (8) so as to produce the said first sides (15) of the chips (19) while the latter remain connected to each other; rotating the so-cut semi-conductor member (8) through 180°; and operating the dicing saw (5) to effect a plurality of second cuts in the semi-conductor member (8) so as to provide the said chips (9) with the said second sides (16).

2. A method as claimed in claim 1 characterised in that the acute angle ($\theta$) is arranged to be $\theta$ = arc. tan $\left(\frac{2t}{\ell}\right)$, where t = the thickness of the semiconductor member (8) and $\ell$ equals the difference between the lengths of the said obverse and reverse sides (12,13).

3. A method as claimed in claim 1 or 2 characterised in that the obverse side (12) is at least 10 $\mu$m longer than the reverse side (13).

4. A method as claimed in any preceding claim characterised in that the circuit includes a light-receiving or a light-emitting element.

5. A method as claimed in any preceding claim characterised in that the semiconductor chips (9) are assembled to form an image sensor.

**Revendications**

1. Un procédé de fabrication de puces de semiconducteurs comprenant la fabrication d'un ensemble de puces de semiconducteurs (9), chacune d'elles ayant une section transversale trapézoîdale et une face supérieure (12) dans laquelle est formé un circuit, un face inférieure (13) qui est plus courte que la face supérieure (12), et des premier et second côtés (15, 16), chacun d'eux s'étendant entre les faces supérieure et inférieure (12, 13), caractérisé en ce qu'on monte tout d'abord un élément semiconducteur (8) sur une surface de support (14) qui est placée de façon à faire un angle aigu avec un scie de découpage en puces (5), et on actionne la scie de découpage en puces pour réaliser un ensemble de premières coupures dans l'élément semiconducteur (8), afin de former les premiers côtés (15) des puces ( 9), tandis que ces dernières restent fixées les unes aux autres; on fait tourner sur 180° l'élément semiconducteur (8) ainsi coupé; et on fait fonctionner la scie de découpage en puces (5) pour réaliser un ensemble de secondes coupures dans l'élément semiconducteur (8), de façon à former les seconds côtés (16) des puces (9).

2. Un procédé selon la revendication 1, caractérisé en ce que l'angle aigu ($\theta$) est choisi conformément à la relation $\theta$ = arc tan$\left(\frac{2t}{\ell}\right)$, dans laquelle t est l'épaisseur de l'élément semiconducteur (8) et $\ell$ est égal à la différence entre les longueurs des faces supérieure et inférieure (12, 13).

3. Un procédé selon la revendication 1 ou 2, caractérisé en ce que la face supérieure (12) mesure au moins 10 $\mu$m de longueur de plus que la face inférieure (13).

4. Un procédé selon l'une quelconque des revendications précédentes, caractérisé en ce que le circuit comprend un élément de réception de lumière ou un élément d'émission de lumière.

5. Un procédé selon l'une quelconque des revendications précédentes, caractérisé en ce que les puces de semiconducteurs (9) sont assemblées pour former un capteur d'image.

**Patentansprüche**

1. Verfahren zur Herstellung von Halbleitersystemen, bei dem eine Vielzahl von Halbleitersystemen (9) mit trapezförmigem Querschnitt hergestellt wird, die eine eine Schaltung enthaltende Vorderseite (12), eine im Vergleich zur Vorderseite kürzere Rückseite (13) sowie eine erste und zweite zwischen der Vorderseite und der Rückseite (12, 13) verlaufende erste und zweite Seite (15, 16) aufweisen, **dadurch gekennzeichnet,** daß ein Halbleiterelement (8) zunächst auf einer Trägerfläche (14) montiert wird, welche unter einem spitzen Winkel zu einer Schnittsäge (5) angeordnet ist und so betätigt wird, daß eine Vielzahl von ersten Sägeschnitten im Halbleiterele-ment (8) erzeugt wird, um die ersten Seiten (15) der noch verbunden bleibenden Systeme (19) herzustellen, daß das so geschnittene Halbleiterelement (8) um 180° gedreht wird und daß die Schnittsäge (5) betätigt wird, um eine Vielzahl von zweiten Schnitten im Halbleiterelement (8) zu erzeugen, wodurch die zweiten Seiten (16) der Systeme (9) entstehen.

2. Verfahren nach Anspruch 1, **dadurch gekennzeichnet,** daß der spitze Winkel (8) gemäß der Beziehung $\theta$ = arc. tan $\left(\frac{2t}{\ell}\right)$ gewählt wird, worin t die Dicke des Halbleiterelementes (8) und 1 die Differenz der Längen der Vorder- und Hinterseite (12, 13) bedeuten.

3. Verfahren nach Anspruch 1 oder 2, **dadurch gekennzeichnet,** daß die Vorderseite (12) wenigstens 10 $\mu$m länger als die Rückseite (13) ist.

4. Verfahren nach den vorhergehenden Ansprüchen, **dadurch gekennzeichnet,** daß die Schaltung ein lichtaufnehmendes oder ein lichtemittierendes Element enthält.

5. Verfahren nach den vorhergehenden Ansprüchen, **dadurch gekennzeichnet,** daß die Halbleitersysteme (9) zur Bildung eines Bildsensors Zusammengefügt werden.

# F I G. 1A

θ < 90°

SEMICONDUCTOR SUBSTRATE 8

5 BLADE OF DICING SAW

15

12

13

8

7 ADHESIVE SHEET

6 STAGE

14

# F I G. 1B

16

15  9

5  8

7

6

# F I G. 1C

9  11  15  9  10  9  17  9  12

ℓ GAP

ℓ

ℓ

13

16

11 DUSTY PARTICLE

PRIOR ART

F I G. 2